(19) **Europäisches Patentamt**

**European Patent Office**

**Office européen des brevets**

(11) **EP 1 014 574 A1**

(12) **DEMANDE DE BREVET EUROPEEN**

(43) Date de publication:
28.06.2000 Bulletin 2000/26

(51) Int. Cl.⁷: **H03H 17/02**, H03H 17/06

(21) Numéro de dépôt: **99204185.5**

(22) Date de dépôt: **07.12.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **15.12.1998 FR 9815837**

(71) Demandeur:
**Koninklijke Philips Electronics N.V.**
**5621 BA Eindhoven (NL)**

(72) Inventeurs:
- **Dujardin, Eric**
  **75008 Paris (FR)**
- **Gay-Bellile, Olivier**
  **75008 Paris (FR)**

(74) Mandataire: **Chaffraix, Jean**
**Société Civile S.P.I.D.**
**156, Boulevard Haussmann**
**75008 Paris (FR)**

(54) **Récepteur, dispositif et procédé de filtrage numérique.**

(57)     L'invention présente une méthode de calcul de filtre destinée à être mise en oeuvre dans un microprocesseur de type multimédia pour augmenter sa puissance de calcul et diminuer sa consommation de mémoire. Il s'agit principalement de définir un opérateur de calcul capable d'effectuer des calculs selon deux niveaux de parallélisme pour contribuer à plusieurs résultats de filtre en une même opération de calcul.

Ainsi, une partie des calculs nécessaires à l'obtention d'un résultat de filtre donné, noté $y_{n+1}$, est-elle effectuée sans attendre que le calcul du résultat précédent, noté $y_n$, soit achevé.

Application : processeurs multimédia, set top boxes, récepteurs de télévision numérique, etc.

FIG.2

**Description**

L'invention concerne un récepteur comportant un dispositif de filtrage numérique pour filtrer des données d'entrée physiques et pour fournir une suite de résultats de filtre, le dispositif comprenant au moins un organe de calcul pour effectuer des calculs intermédiaires destinés à exécuter en parallèle une pluralité de produits entre les données d'entrée et des coefficients prédéterminés.

Elle concerne également un dispositif de filtrage numérique pour filtrer des données physiques d'entrée et pour fournir une suite de résultats de filtre, le dispositif comprenant au moins :

- une mémoire de stockage pour stocker par paquets les données physiques d'entrée et des coefficients prédéterminés et
- un organe de calcul susceptible d'exécuter en parallèle une pluralité de produits entre les données d'entrée et les coefficients prédéterminés pour fournir des résultats intermédiaires destinés à contribuer à un résultat de filtre donné.

L'invention concerne enfin un procédé de filtrage numérique pour calculer une suite de résultats de filtre et comportant au moins une sous-étape de calcul intermédiaire pour exécuter une pluralité de produits en parallèle entre des données physiques d'entrée et des coefficients prédéterminés en vue de contribuer à un résultat de filtre donné.

Elle a de nombreuses applications notamment dans des systèmes dits 〈〈 multimédia 〉〉 pour réaliser des filtres numériques en utilisant, par exemple, un processeur de signal, du genre dit DSP, avec des algorithmes spécialisés.

Le document de Curtis Abbott et al., intitulé 〈〈Broadband Algorithm with the MicroUnity Mediaprocessor〉〉 présenté entre le 25 et le 29 février 1996 lors de la conférence COMPCON96 de l'IEEE, décrit un processeur destiné à des applications de type multimédia comportant notamment du filtrage numérique, capable de réaliser des calculs de produits en parallèle sur des paquets ou mots de données pour traiter des trames de données reçues selon un certain débit.

L'invention décrit une méthode plus économique en terme de place mémoire utilisée et plus efficace en terme de puissance de calcul, pour réaliser des calculs de filtre, notamment à l'aide d'un microprocesseur programmable capable de traiter tous types de données physiques, audio, vidéo, etc.

Le document cité divulgue une méthode de calcul à un niveau de parallélisme pour effectuer en parallèle à l'aide d'un processeur spécialement programmé, une pluralité de produits entre des données d'entrée et des coefficients prédéterminés; plusieurs processeurs du même type pouvant travailler en parallèle pour augmenter la vitesse globale d'exécution des calculs. A titre d'exemple, pour calculer une suite de résultats de filtre, notée $[y_n]$, avec:

$$y_n = \sum_{i=0}^{L-1} \omega_i \times x_{n-i} \qquad (1)$$

où L est la longueur du filtre, $y_n$ le résultat du filtre à l'instant n, $\omega_i$ le coefficient prédéterminé d'indice i et $x_{n-i}$, la donnée physique reçue à l'instant n-i, le processeur calcule des résultats intermédiaires obtenus en calculant la somme de produits suivante:

$$\sum_{i=0}^{p-1} bi \times ai \qquad (2)$$

p étant le nombre entier de données ai ou bi traitées en parallèle (ai représentant les données d'entrée et bi, les coefficients), ce nombre p correspondant au nombre de données ai ou bi mémorisées dans une même entité de stockage, appelée paquet ou encore mot de données.

Le nombre de calculs nécessaires à l'obtention de la suite des résultats de filtre $[y_n]$, est ainsi déjà globalement réduit du fait qu'un certain nombre de produits sont effectués en parallèle en vue de contribuer à un résultat de filtre $y_n$ donné.

Un objet de l'invention est de réduire encore le nombre global de calculs nécessaires à l'obtention de la suite $[y_n]$ en ajoutant un degré de parallélisme supplémentaire entre les calculs intermédiaires.

Pour cela, il est prévu un récepteur et un dispositif du genre de ceux mentionnés dans le paragraphe introductif, remarquables en ce que en ce que ledit organe comprend au moins un opérateur de calcul pour effectuer plusieurs calculs intermédiaires en parallèle en vue de contribuer à plusieurs résultats de filtre.

Un autre objet de l'invention est d'économiser la place mémoire utilisée pour calculer les résultats de filtre $y_n$ successifs.

Selon une caractéristique importante de l'invention, les données correspondant aux données physiques d'entrée ou aux coefficients prédéterminés étant stockées par paquets dans des registres de mémoire et lesdites données étant susceptibles d'être impliquées dans plusieurs calculs intermédiaires, ledit organe comporte une paire d'opérateurs de calcul pour achever en au plus deux opérations de calcul successives, tous les calculs intermédiaires impliquant les données d'un paquet.

Selon une autre caractéristique de l'invention, un paquet pouvant contenir un nombre entier de données d'entrée ou de coefficients, noté p, chaque opérateur est défini pour effectuer p calculs intermédiaires en parallèle et pour contribuer à p résultats de filtre successifs.

De même, il est prévu un procédé du genre mentionné dans le paragraphe introductif, remarquable en ce qu'il comprend une étape de calcul parallèle pour réaliser en parallèle plusieurs sous-étapes de calcul intermédiaire en vue de contribuer à plusieurs résultat de filtre.

La description suivante, faite en regard des dessins ci-annexés, le tout donné à titre d'exemple non limitatif fera bien comprendre comment l'invention peut être réalisée.

La figure 1 est un schéma illustrant un procédé de calcul selon l'art antérieur.
La figure 2 est un schéma pour illustrer un procédé de filtrage selon l'invention.
Les figures 3 et 4 illustrent un mode de réalisation d'un opérateur de calcul selon l'invention pour réaliser deux opérations de calcul successives.
La figure 5 illustre un exemple de dispositif de filtrage selon l'invention.
La figure 6 illustre un exemple de récepteur selon l'invention.

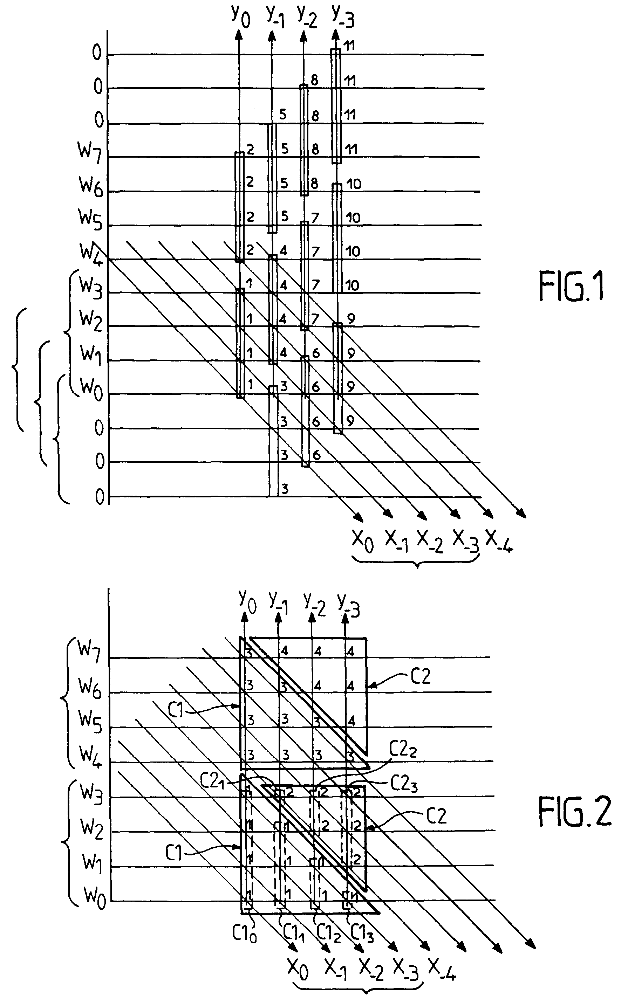

Le schéma de la figure 1 illustre un procédé de calcul de filtre selon la méthode décrite dans le document d'art antérieur cité plus haut pour calculer une suite de résultat de filtres $y_n$ obtenus selon l'équation (1), à l'aide de calculs intermédiaires parallèles effectués selon l'équation (2). Dans l'exemple représenté à la figure 1, l'entité de stockage appelée mot ou paquet contient quatre données d'entrée ou coefficient, soit p = 4.

Les coefficient prédéterminés notés $\omega_i$ sont représentés sur les lignes horizontales tandis que les données d'entrée $x_{-n}$ à $x_0$ sont représentées sur les diagonales. L'intersection d'une horizontale avec une diagonale indique un produit entre la donnée d'entrée et le coefficient correspondant. Un indice de temps croissant compris entre 1 et 11 est représenté à côté de chaque produit. Les produit ayant le même indice sont exécutés et additionnés en même temps, en un seul calcul intermédiaire indiqué par un rectangle entourant ces produits. Des accolades regroupent les coefficient $\omega_i$ et les données d'entrée $x_i$ contenus respectivement dans un mot à un instant donné pour être impliqués dans un même calcul intermédiaire parallèle. Les résultat de filtre $y_n$ sont obtenus en additionnant les résultat des calculs intermédiaires situés sur une même ligne verticale. D'après l'exemple illustré, 11 calculs intermédiaires parallèles sont nécessaires pour obtenir les quatre résultat de filtre $y_{-3}$ à $Y_0$.

Selon ce procédé, tous les calculs destinés à contribuer à un résultat de filtre donné, noté $y_n$, sont achevés avant de commencer le calcul du résultat suivant, noté $y_{n+1}$.

En considérant chaque calcul intermédiaire comme une seule opération dans le procédé de calcul, le nombre total d'opérations effectuées pour calculer un résultat de filtre $y_n$ selon la méthode connue est égal en moyenne à :

$$\frac{L}{p}op+\frac{L-1}{p}ad+\frac{L}{p}move=O\left(\frac{3L}{p}\right)$$

où *op* indique une opération de calcul correspondant à un calcul parallèle, *ad* indique une addition et *move* une opération élémentaire de décalage effectuée sur les mots pour simuler une mémoire circulaire. Le symbole *O* signifie《 de l'ordre de》.

Les mots de données, le terme données comprenant ici indifféremment les données d'entrée ou les coefficients, sont préalablement stockés dans des tampons de mémoire dont la taille nécessaire dépend de la longueur du filtre, notée L, et de l'ordre d'exécution des produits lors des différents calculs. Dans l'exemple illustré à la figure 1, le procédé consomme 11 places mémoire pour stocker les mots de coefficients impliqués dans le calcul des résultats de filtre $y_{-3}$ à $y_0$.

La mémoire nécessaire correspond ainsi en moyenne, à un tampon pour contenir $L/p$ + 1 mots de données d'entrée $x_i$ et p tampons de $L/p$ + 1 mots pour les coefficients $\omega_i$ prédéterminés. La taille mémoire consommée par le procédé est donc, en nombre de mots de p données, de l'ordre de:

$$\frac{p+1}{p}\times(L+p)$$

Une autre méthode va maintenant être décrite, selon l'invention, pour réduire le nombre d'opérations et la taille mémoire nécessaires au calcul d'une suite de résultats de filtre selon l'équation (1).

Un mode de réalisation préféré d'un procédé pour mettre en oeuvre cette méthode est illustré sur un exemple à la figure 2. Il peut être réalisé, par exemple, à l'aide d'un processeur de signal de type DSP.

Les coefficients prédéterminés notés $\omega_i$ sont représentés, comme à la figure 1, sur les lignes horizontales tandis que les données d'entrée $x_{-n}$ à $x_0$ sont représentées sur les diagonales. L'intersection d'une horizontale avec une diagonale, indiquant un produit entre la donnée et le coefficient correspondant, est affectée d'un indice de temps croissant pour désigner les produits effectués en parallèle dans une même opération de calcul, indiquée dans un triangle. Les données d'entrée ou les coefficients prédéterminés, préalablement stockées par paquets dans des tampons de mémoire en vue d'être utilisées ultérieurement pour les calculs, sont susceptibles d'être impliquées dans plusieurs calculs intermédiaires parallèles.

Le procédé qui va être décrit ci-après permet d'une part, de réduire la taille de ces mémoires qui dépend bien entendu de la taille du filtre, notée L, mais aussi de l'ordre d'exécution des produits et d'autre part, de réduire le nombre d'opérations nécessaires, en introduisant un deuxième degré de parallélisme entre les calculs intermédiaires parallèles.

Pour cela, le procédé comporte au moins une étape de calcul parallèle consistant à effectuer en parallèle plusieurs sous-étapes de calcul, dites sous-étapes intermédiaires, destinées à calculer des résultats intermédiaires exécutant chacun plusieurs produits en parallèle pour contribuer à plusieurs résultats de filtre en une même étape de calcul. Contrairement à la méthode connue, le procédé n'attend pas que tous les calculs destinés à contribuer à un résultat de filtre donné $y_n$ soient achevés avant de commencer à calculer le résultat suivant noté $Y_{n+1}$.

Dans l'exemple illustré à la figure 2, le procédé comprend deux étapes successives de calcul parallèle définies par deux opérations, notées C1 et C2, utilisant deux opérandes, notées $\{a_0, a_1,..., a_{p-2}, a_{p-1}\}$ et $\{b_0, b_1,..., b_{p-2}, b_{p-1}\}$. Chaque étape réalise en parallèle p sous-étapes intermédiaires pour calculer p résultats intermédiaires destinés à contribuer à p résultats de filtre.

Ces résultats intermédiaires, notés $C1_0$ à $C1_{p-1}$ pour l'opération C1 et $C2_0$ à $C2_{p-1}$ pour l'opération C2, sont contenus respectivement dans un mot. Leurs équations s'écrivent :

$$C1_j = \sum_{i=0}^{p-j-1} a_{i+j} \times b_i \qquad j \in [0...p\text{-}1] \qquad (5)$$

$$C2_j = \sum_{i=0}^{j-1} a_i \times b_{p+i-j} \qquad j \in [1...p\text{-}1] \qquad (6)$$

On a donc avec p = 4 :

$$C1_0 = a_0 b_0 + a_1 b_1 + a_2 b_2 + a_3 b_3$$

$$C1_1 = a_1 b_0 + a_2 b_1 + a_3 b_2$$

$$C1_2 = a_2 b_0 + a_3 b_1$$

$$C1_3 = a_3 b_0$$

$$C2_0 = 0$$

$$C2_1 = a_0 b_3$$

$$C2_2 = a_0 b_2 + a_1 b_3$$

$$C2_3 = a_0 b_1 + a_1 b_2 + a_2 b_3$$

Un même mot de coefficients ou de données d'entrée représenté entre accolades sert dans deux opérations ou étapes de calcul parallèle successives réalisant chacune quatre sous-étapes intermédiaires pour calculer au total 16 produits. Ces 16 produits calculés en deux opérations ou étapes de calcul parallèle successives sont destinés à contribuer aux quatre résultats de filtre $y_{-3}$ à $y_0$ alors qu'aucun des calculs aboutissant à l'un de ces résultats de filtre n'est achevé. Les résultats $y_{-3}$ à $y_0$ sont finalement obtenus au bout de deux séries d'étapes successives de calcul parallèle réalisant 32 produits.

Dans l'exemple de la figure 2, les mots $\{\omega 0,...,\omega 4\}$ et $\{x_{-4},...,x_0\}$ sont impliqués dans une première opération de type C1, avec $a_i = x_{-i}$ et $b_i = \omega i$, représentée par le triangle inférieur à indices 1 et dans une deuxième opération de type C2, avec $a_i = x_{-(p+i)}$ et $b_i = \omega_i$, représentée par le triangle supérieur à indices 2. Les calculs intermédiaires $C1_0$ à $C1_3$ et $C2_0$, à $C2_3$ effectués en parallèle selon les deux plans de parallélisme décrits plus haut sont indiqués par des rectangles représentés en pointillés à l'intérieur de chacun des triangles C1 et C2. $C2_0$ étant nul il n'est pas représenté sur la figure 2.

Le procédé permet ainsi d'exécuter $p \times p$ produits en deux opérations ou étapes successives à l'aide de deux opérateurs, le nombre total d'opérations nécessaires au calcul d'un résultat de filtre est alors égal à :

$$\frac{1}{p} \times \left( \frac{2 \times Lp}{p^2} op + \frac{2 \times Lp\text{-}p}{p^2} ad + \frac{L}{p} move \right) = O\left( \frac{5L}{p^2} \right)$$

où *op* indique une opération de calcul correspondant à un calcul parallèle, *ad* indique une addition et *move* une opération élémentaire de décalage effectuée sur les mots pour simuler un tampon circulaire. Le symbole *O* signifie 〈〈 de l'ordre de 〉〉.

En ce qui concerne la mémoire consommée, le procédé est particulièrement avantageux puisque les données sont organisées de façon optimale pour économiser de la place dans les registres. En effet, selon l'exemple de la figure 2, deux mots suffisent pour mémoriser les coefficients $\omega_0$ à $\omega_7$ impliqués dans le procédé illustré alors que 11 mots étaient nécessaires selon la méthode connue décrite en référence à la figure 1. De façon générale, la mémoire consommée par le procédé selon l'invention correspond, en nombre de mots, à :

$$O\left( \frac{2L}{p} \right)$$

Le procédé illustré par la figure 2 permet ainsi d'obtenir les résultats $y_{-3}$ à $y_0$, au bout de deux séries d'étapes successives de calcul parallèle, soit en neuf opérations réalisant 32 produits et consomme 2 mots de mémoire pour les coefficients prédéterminés, alors que selon la méthode connue décrite précédemment, les 32 produits étaient obtenus au bout de 23 opérations en consommant 11 places ou mots de mémoire.

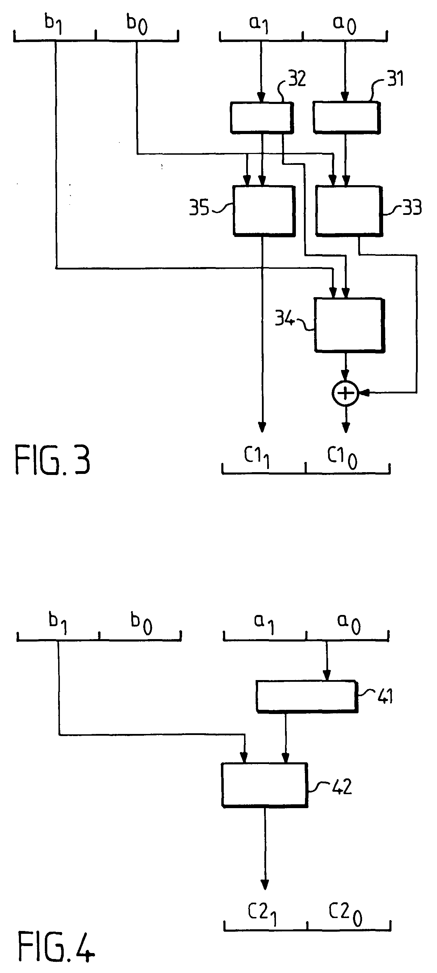

Les figures 3 et 4 illustrent la structure d'un opérateur selon l'invention pour calculer plusieurs résultats intermédiaires en parallèle en vue de contribuer à plusieurs résultats de filtre successifs. L'opérateur, représenté à titre d'exemple pour réaliser le calcul des équations de type C1 et C2, peut avantageusement être implémenté dans un multiplieur à l'intérieur d'un processeur de signal de type DSP. Il peut également être réalisé à partir de deux multiplieurs distincts réalisant chacun un type d'opération.

Pour simplifier les figures 3 et 4, les mots de données d'entrée et de coefficients prédéterminés, notés $\{a_0, a_1\}$ et $\{b_0, b_1\}$, contiennent deux données seulement, chaque donnée étant codée sur un nombre entier N/2 de bits, notés $a(0)$ à $a(N-1)$ et $b(0)$ à $b(N-1)$. Les résultats des calculs intermédiaires, notés $\{C1_0, C1_1\}$ pour l'opérateur $C_1$ et $\{C2_0, C2_1\}$ pour l'opérateur C2, sont contenus respectivement dans un mot. Plus le nombre de données par mot est élevé, plus l'invention est avantageuse. C'est pourquoi tous les avantages apportés par l'invention n'apparaissent pas forcément sur les figures 3 et 4.

La plupart des multiplieurs classiques remédient au problème des données négatives en encodant préalablement les données selon une technique de codage bit à bit, dite codage de booth, pour permettre de multiplier des données sans se soucier de leur signe. Selon cette technique classique, une multiplication entre deux données a et b codées sur n bits s'écrit:

$$a \times b = \sum_{i=0}^{n-1} b(a(i\text{-}1)\text{-}a(i))2^{i} \qquad (7)$$

où $a(i)$ indique le $i^{\text{ième}}$ bit de la donnée a, $a(-1)$ étant nul. Le codage de booth effectue le calcul bit à bit correspondant à $(a(i - 1) - a(i))2^{i}$.

La figure 3 représente l'organisation d'un multiplieur pour le calcul de l'opération C1. Il comporte deux blocs d'encodage ou codeur de booth 31 et 32, destinés à réaliser un codage bit à bit, ou de booth, sur chaque donnée du mot de données d'entrée $a_0$ et $a_1$. Cependant, le codage de booth peut être effectué indifféremment sur l'une des deux données participant à la multiplication, la donnée d'entrée $a_i$ ou bien le coefficient $b_i$. La sortie du premier codeur de booth 31 et la donnée $b_0$ sont fournies en entrée d'un premier additionneur 33 pour effectuer une multiplication suivant l'équation (5) entre les données $a_0$ et $b_0$. En parallèle, un deuxième additionneur 34 reçoit la donnée $b_1$ et la sortie du deuxième codeur de booth 32 pour effectuer la multiplication entre les données $a_1$ et $b_1$ selon l'équation (5). Les résultats des premier et deuxième additionneurs 33 et 34 sont ensuite additionnés pour fournir un premier résultat intermédiaire noté $C1_0 = a_0 \times b_0 + a_1 \times b_1$.

Parallèlement, selon le deuxième degré de parallélisme prévu par l'invention, un troisième additionneur reçoit la donnée $b_0$ et la sortie du deuxième codeur de booth pour multiplier les données $a_1$ et $b_0$ selon l'équation (5) et fournir le deuxième résultat intermédiaire $C1_1 = a_1 \times b_0$.

Sur la figure 4, représentant l'organisation d'un multiplieur pour le calcul de l'opération C2, un seul bloc d'encodage 41, ou codeur de booth, est suffisant pour réaliser un codage bit à bit, ou de booth, sur la première donnée $a_0$ du mot de données d'entrée. La sortie du codeur ainsi que la donnée $b_1$ sont fournies en entrée d'un additionneur 42 pour réaliser la multiplication, selon l'équation (6), de ces deux données et obtenir le résultat intermédiaire $C2_1 = a_0 \times b_1$, $C2_0$ étant nul.

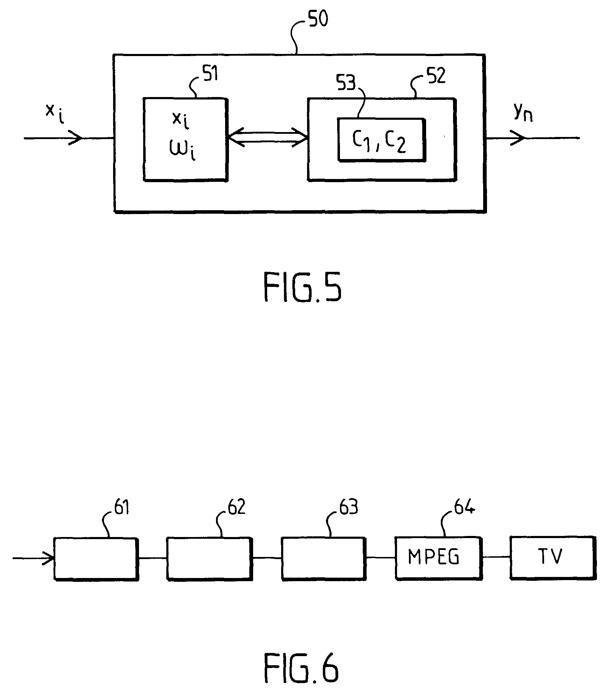

Le dispositif de filtrage 50 représenté à la figure 5 comporte :

- une mémoire de stockage 51 pour stocker les données d'entrée physiques (audio, vidéo, etc.), notées $x_i$, ainsi que des coefficients de filtre prédéterminés $\omega i$ et
- un organe de calcul 52 pour calculer les résultats de filtre $y_n$ à partir des données d'entrée $x_i$, selon l'équation (1).

L'organe de calcul 52 peut être notamment un processeur de signal numérique du genre DSP et comprend un opérateur de calcul 53 du type multiplieur pour calculer des résultats intermédiaires destinés à contribuer à plusieurs résultats de filtre $y_n$ successifs. L'organisation du multiplieur 53 est celle décrite en référence aux figures 3 et 4 pour réaliser des opérations de type C1 et C2 destinées à calculer les résultats intermédiaires.

La figure 6 montre, à titre d'exemple de réalisation, un schéma général d'un récepteur de télévision numérique classique susceptible de comporter un dispositif de filtrage tel que celui illustré à la figure 5 pour filtrer des données d'entrée obtenues à partir de trames de données transmises sur un canal de transmission et reçues par le récepteur. Celui-ci comporte:

- un bloc 61 comprenant un tuner pour recevoir un signal d'entrée analogique et le convertir dans une fréquence intermédiaire plus basse,
- un bloc de démodulation 62 pour numériser le signal analogique reçu et le démoduler afin d'assurer la synchronisation des données constituant le signal sous forme de trames de données numériques,
- un bloc de correction d'erreur 63 pour corriger les erreurs de transmission dues au canal,
- un bloc de décodage de source 64 utilisant, par exemple, un décodeur selon la norme MPEG pour décoder le message reçu et
- un bloc de visualisation 65 comprenant notamment un tube cathodique TV.

Un filtrage numérique est nécessaire pour assurer la fonction du démodulateur 62 et peut être réalisé de façon avantageuse, à l'aide du dispositif selon l'invention, représenté à la figure 5.

Ainsi ont été décrits et illustrés à l'aide d'exemples un récepteur, un dispositif et un procédé de filtrage numérique optimisés en terme de puissance de calcul et de consommation de mémoire. Bien entendu, de nombreuses variantes de réalisation pourront être apportées sans sortir du cadre de l'invention.

## Revendications

1.  Récepteur comportant un dispositif de filtrage numérique pour filtrer des données physiques d'entrée et pour fournir une suite de résultats de filtre, le dispositif comprenant au moins un organe de calcul pour effectuer des calculs intermédiaires destinés à exécuter en parallèle une pluralité de produits entre les données d'entrée et des coefficients prédéterminés,
caractérisé en ce que ledit organe comprend au moins un opérateur de calcul pour effectuer plusieurs calculs intermédiaires en parallèle en vue de contribuer à plusieurs résultats de filtre.

2.  Récepteur selon la revendications 1, les données correspondant aux données physiques d'entrée ou aux coefficients prédéterminés étant stockées par paquets dans des registres de mémoire et lesdites données étant susceptibles d'être impliquées dans plusieurs calculs intermédiaires,
caractérisé en ce que ledit opérateur comporte des moyens de calcul pour effectuer en au plus deux opérations de calcul successives, tous les calculs intermédiaires impliquant les données d'un paquet.

3.  Récepteur selon la revendication 2, un paquet pouvant contenir un nombre entier de données d'entrée ou de coefficients, noté p, caractérisé en ce que chaque opération est définie pour effectuer p calculs intermédiaires en parallèle et pour contribuer à p résultats de filtre successifs.

4.  Récepteur selon l'une des revendications 2 ou 3, la suite de résultats de filtre, notée $[y_n]$, pouvant s'écrire :

$$y_n = \sum_{i=0}^{L-1} \omega_i \times x_{n-i}$$

où L est la longueur du filtre numérique, $y_n$ le résultat du filtre à l'instant n, $\omega_i$ le coefficient prédéterminé d'indice i et $x_{n-i}$, la donnée physique reçue à l'instant n-i, caractérisé en ce que les deux opérations sont définies par les équations op1 et op2 suivantes:

$$op1_j = \sum_{i=0}^{p-j-1} x_{-(i+j)} \times \omega_i \qquad j \in [0...p\text{-}1]$$

$$op2_j = \sum_{i=p}^{p+j-1} x_{-i} \times \omega_{i-j} \qquad j \in [1...p\text{-}1]$$

où p est un entier fixé représentant le nombre de données physiques ou de coefficients contenues dans un paquet.

5.  Dispositif de filtrage numérique pour filtrer des données physiques d'entrée et pour fournir une suite de résultats de filtre, le dispositif comprenant au moins :

    •   une mémoire de stockage pour stocker les données physiques d'entrée et des coefficients prédéterminés par paquets,
    •   un organe de calcul susceptible d'exécuter en parallèle une pluralité de produits entre les données d'entrée et les coefficients prédéterminés pour fournir des résultats intermédiaires destinés à contribuer à un résultat de filtre donné,

caractérisé en ce que ledit organe comprend au moins un opérateur de calcul pour calculer plusieurs résultats intermédiaires en parallèle en vue de contribuer à plusieurs résultats de filtre.

6.  Dispositif selon la revendications 5, les données d'entrée et les coefficients étant susceptibles d'être impliquées dans plusieurs calculs intermédiaires parallèles, caractérisé en ce que ledit opérateur comporte des moyens de calcul pour calculer en au plus deux opérations successives, tous les résultats intermédiaires impliquant le contenu d'un paquet.

7.  Procédé de filtrage numérique pour calculer une suite de résultats de filtre et comportant au moins une sous-étape de calcul intermédiaire pour exécuter une pluralité de produits en parallèle entre des données physiques d'entrée et des coefficients prédéterminés en vue de contribuer à un résultat de filtre donné,
caractérisé en ce qu'il comprend au moins une étape de calcul parallèle pour réaliser en parallèle plusieurs sous-étapes de calcul intermédiaire en vue de contribuer à plusieurs résultats de filtre.

8.  Procédé selon la revendication 7, comportant une étape préalable de stockage pour stocker par paquets les données correspondant aux données physiques d'entrée ou aux coefficients prédéterminés en vue de les utiliser dans des sous-étapes de calcul intermédiaire, lesdites données étant susceptibles d'être impliquées dans plusieurs sous-étapes de calcul intermédiaire, caractérisé en ce qu'il comporte deux étapes de calcul parallèle successives pour réaliser toutes les sous-étapes de calcul intermédiaire impliquant les données contenues dans un paquet.

9. Procédé selon la revendication 8, un paquet pouvant contenir un nombre entier de données d'entrée ou de coefficients, noté p, caractérisé en ce que chacune des deux étapes de calcul parallèle successives est définie pour réaliser en parallèle p sous-étapes de calcul intermédiaire et pour contribuer à p résultats de filtre successifs.

10. Procédé selon l'une des revendication 8 ou 9, la suite de résultats de filtre, notée $[y_n]$, pouvant s'écrire :

$$y_n = \sum_{i=0}^{L-1} \omega_i \times x_{n-i}$$

où L est la longueur du filtre numérique, $y_n$ le résultat du filtre à l'instant n, $\omega_i$ le coefficient prédéterminé d'indice i et $x_{n-i}$, la donnée physique reçue à l'instant n-i, caractérisé en ce que les deux étapes de calcul parallèle successives réalisent les opérations op1 et op2 suivantes :

$$op1_j = \sum_{i=0}^{p-j-1} x_{-(i+j)} \times \omega_i \qquad j \in [0...p\text{-}1]$$

$$op2_j = \sum_{i=p}^{p+j-1} x_{-i} \times \omega_{i-j} \qquad j \in [1...p\text{-}1]$$

où p est un entier fixé représentant le nombre de données physiques ou de coefficients contenues dans un paquet.

FIG.1

FIG.2

FIG. 3

FIG. 4

*50*

$x_i$ → | 51 $x_i$ $\omega_i$ | ⟷ | 52 | 53 $C_1, C_2$ | → $y_n$

## FIG.5

61 → 62 → 63 → 64 MPEG → TV

## FIG.6

**EP 1 014 574 A1**

Office européen
des brevets

**RAPPORT DE RECHERCHE EUROPEENNE**

Numéro de la demande

EP 99 20 4185

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EL-GUIBALY F ET AL: "SYSTOLIC IMPLEMENTATION OF FIR FILTERS" SIGNAL PROCESSING THEORIES AND APPLICATIONS, BARCELONA, SEPT. 18 - 21, 1990, vol. 3, no. CONF. 5, 18 septembre 1990 (1990-09-18), pages 1423-1426, XP000365826 TORRES L;MASGRAU E; LAGUNAS M A --- | 1,5 | H03H17/02 H03H17/06 |
| A | PATENT ABSTRACTS OF JAPAN vol. 16, no. 31 (E-1159), 27 janvier 1992 (1992-01-27) & JP 03 244210 A (TEREMATEI KOKUSAI KENKYUSHO), 31 octobre 1991 (1991-10-31) * abrégé * ----- | 1,5 | |

| | DOMAINES TECHNIQUES RECHERCHES (Int.Cl.7) |
|---|---|
| | H03H |

Le présent rapport a été établi pour toutes les revendications

| Lieu de la recherche | Date d'achèvement de la recherche | Examinateur |
|---|---|---|
| LA HAYE | 17 mars 2000 | Coppieters, C |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 99 20 4185

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-03-2000

| Document brevet cité au rapport de recherche | Date de publication | Membre(s) de la famille de brevet(s) | Date de publication |
|---|---|---|---|
| JP 03244210 A | 31-10-1991 | JP 2090189 C<br>JP 7109988 B | 02-09-1996<br>22-11-1995 |

EPO FORM P0460

Pour tout renseignement concernant cette annexe : voir Journal Officiel de l'Office européen des brevets, No.12/82